Europäisches Patentamt

European Patent Office

Office européen des brevets

Publication number: **0 287 064**
**A2**

## EUROPEAN PATENT APPLICATION

Application number: 88105881.2

Date of filing: 13.04.88

Int. Cl.⁴: **H01B 12/00 , H01L 39/24 ,
C04B 35/50**

Priority: 16.04.87 JP 92091/87
21.05.87 JP 122583/87
29.06.87 JP 159886/87

Date of publication of application:
**19.10.88 Bulletin 88/42**

Designated Contracting States:
**DE FR GB**

Applicant: **NIPPON STEEL CORPORATION**
6-3 Otemachi 2-chome Chiyoda-ku
Tokyo 100(JP)

Inventor: **Suyama, Ryuji** c/o Nippon Steel
**Corporation**
**R&D Laboratories-I 1618, Ida Nakahara-ku**
**Kawasaki-shi Kanagawa(JP)**
Inventor: **Inuzuka, Takayuki** c/o Nippon Steel
**Corporation**
**R&D Laboratories-I 1618, Ida Nakahara-ku**
**Kawasaki-shi Kanagawa(JP)**
Inventor: **Kubo, Hiroshi** c/o Nippon Steel
**Corporation**
**R&D Laboratories-I 1618, Ida Nakahara-ku**
**Kawasaki-shi Kanagawa(JP)**
Inventor: **Tanemoto, Kei** c/o Nippon Steel
**Corporation**
**R&D Laboratories-I 1618, Ida Nakahara-ku**
**Kawasaki-shi Kanagawa(JP)**

Representative: **Vossius & Partner**
**Siebertstrasse 4 P.O. Box 86 07 67**
**D-8000 München 86(DE)**

Process for producing superconductive ceramics.

A process for a synthesizing of superconductive
ceramics, which comprises adding a solution con-
taining ions of rare earth elements, alkaline earth
elements and copper into an alcohol solution of
oxalic acid to precipitate oxalates of the rare earth
elements, the alkaline earth elements and copper,
dropwise adding ammonia water to the solution in
which the oxalates are precipitated to adjust a pH
thereof to 2 to 7, and calcining, molding and sinter-
ing the mixture of oxalates of the rare earth element,
alkaline earth metal and Cu obtained by filtration of
the above-mentioned solution.

Fig. 1

# PROCESS FOR PRODUCING SUPERCONDUCTIVE CERAMICS

The present invention relates to a process for producing superconductive ceramics. Superconductive ceramics are molded into linear or band shapes and used for electrical instruments such as generators, transformers and others as well as electronic devices such as a Josephson device, and the like.

As superconductive materials, metal elements, alloys or intermetallic compounds of these metals, organic and ceramics materials are known. Recently, particular attention has been paid to ceramics type the superconductive ceramics of oxides such as $Y Ba_2Cu_3O_{7-x}$ or $La Ba_2CuO_{7-x}$, and the like.

The common way of producing these ceramic superconductors is as follows. That is, at first, the superconductive oxide powder is made by mixing and calcining raw powders, such as $La_2O_3$, $Y_2O_3$, $SrCO_3$, $BaCO_3$, CuO, and subsequently, by pulverizing, molding, and sintering, the powder is made into superconductive ceramics.

In the production of the ceramic superconductors, a denser superconductor can be obtained when the powder used as the starting material has a smaller particle size and a higher dispersibility. If the superconductor is dense, the critical temperature Tc, the critical current density JC, and the critical magnetic field Hc will be higher because the influence of the grain boundary is reduced. Accordingly, electrical instruments with a higher performance and smaller size can be produced. Also, because a fine and complicated working becomes possible, the material can be applied for electronic devices. Accordingly, the densification of superconductive ceramics has a remarkable effect on the improvement of the performances of electrical instruments and electronic devices.

The particles are grown and, therefore, the material is not densified during the sintering. However, when the calcination is carried out at a low temperature, to suppress the particle growth, the carbonate remains.

In the synthetic process of the prior art as described above, since the superconductive oxide powder is synthesized by mixing and calcining the raw powders such as $La_2O_3$, $Y_2O_3$, $SrCO_3$, $BaCO_3$, CuO, and the like.

However, since the alkali earth metal carbonate used in the above-mentioned superconductive oxide product is not easily decomposed, the calcination must be carried out at a high temperature, which carries the growth of the particles. For this reason, it is difficult to make the superconductive ceramic powder fine in size or homogeneous in composition.

Recently, Japanese Patent Publication (Kokoku) JP-B-62-84 proposed the production of perovskite type oxide fine powder in which the oxide $ATiO_3$, wherein A is Pb, Ba, Sr, or Ca, is produced by calcining the oxalates which are synthesized by adding ethanol to an aqueous solution containing titanium ion and A ion in an approximately equi-molecular amount, followed by adding an ethanol solution of oxalic acid to form coprecipitates. However, in making superconductive oxides by the prior art, because of containing copper as an essential constituent, the pH of the solution must be adjusted to 2 to 7, which is not taught in this reference.

Besides, the present invention requires containing a rare earth metal as an essential constituent for the superconductor, which is neither taught in the reference. Furthermore, during calcination, $CO_2$ is generated from the above-mentioned oxalate, which prevents the appearance of the superconductive crystal structure. To produce high performance superconductor, the oxalate must be calcined in the atmosphere of oxygen, which is not taught in the reference.

## SUMMARY OF THE INVENTION

Accordingly, the objects of the present invention are to obviate the above-mentioned problems of the prior art and to provide a process capable of synthesizing superconductive ceramics having a dense structure and a single phase of the superconductive crystal structure.

Other objects and advantages of the present invention will be apparent from the description set forth hereinafter.

In accordance with the process for a synthesis of superconductive ceramics of the present invention, a solution containing ions of at least one rare earth element, at least one alkaline earth element, and copper is added to an alcohol solution of oxalic acid to precipitate oxalates of the rare earth elements, the alkaline earth elements, and copper. Subsequently, ammonia water is added to the solution in which oxalates are precipitated to adjust the pH thereof to 2 to 7, and the above solution is filtered. The mixture of oxalates of the rare earth elements, alkaline earth elements and copper obtained by filtration is then calcined, molded, and sintered.

BRIEF DESCRIPTION OF THE DRAWINGS

The present invention will be better understood from the description set forth below with reference to the drawings in which:

Figure 1 is a diagram of the working steps showing an example of the process for synthesis of super-conductive ceramics when using aqueous solutions of nitrates of Y, Ba and Cu according to the present invention;

Fig. 2 is a graph of the electrical resistances measured for two samples of different lots prepared according to the above working steps;

Fig. 3 is a diagram of the working steps showing an example of the process for synthesizing superconductive ceramics when using aqueous solutions of chlorides of Y, Ba and Cu;

Fig. 4 is an X-ray diffraction chart of the superconductive oxide powder according to the present invention; and

Fig. 5 is an X-ray diffraction chart of the superconductive oxide powder produced by a conventional process.

DESCRIPTION OF THE PREFERRED EMBODIMENT

As the alcohol, for example, methanol, ethanol, or propanol may be employed.

As the solution containing ions of rare earth elements, alkaline earth elements and copper, aqueous solutions of nitrates, chlorides, bromides or aqueous solutions of hydroxides, oxychlorides, thiosulfates, carboxylates of alkaline earth elements may be employed.

Depending upon the type of superconductive ceramics to be synthesized, the necessary elements are selected from rare earth elements and alkaline earth elements. Those selected from rare earth elements may be, for example, La, Eu, Dy, Ho, Er, Tm, Yb, Y or Sc, and those selected from alkaline earth elements may be Mg, Ca, Sr, or Ba.

A mixture of solutions containing ions of rare earth elements, alkaline earth elements and copper may be also added into the alcohol solution of oxalic acid, or alternatively, each of the above solutions may be added to the alcohol solution of oxalic acid, followed by mixing these solutions to form one mixture. Of course, the alcoholic solution of oxalic acid may be added into the mixture of the above solutions, or into each solution individually.

The above mixture should be thoroughly stirred. The adjustment of the pH to the range of 2 to 7 is made to prevent copper ions from dissolving out into the solution, which occurs if the pH exceeds 7. On the other hand, if the pH is lower than 2, it is difficult to form ammonium oxalate, and at the same time, it is difficult to filter the oxalates.

The methods of calcination, molding, and sintering may be exactly the same as in the prior art methods.

More specifically and preferably, the calcining is carried out under a pressure of 0.2 to 1 atm, while subjected to an oxygen stream at an oxygen flow rate of, preferably, 0.1 to 5 liter/liter min (per unit volume of a calcining oven and unit time). When the oxygen flow rate is too small, it is difficult to suppress the grain growth. Conversely, when the oxygen flow rate is too high, the temperature within the calcining oven may be lowered. The preferable calcining temperature is approximately 800 to 1200°C, and the preferable calcining time is approximately 2 to 48 hours. The oxalates are thermally decomposed to form the oxide.

The sintering is preferably carried out under a normal pressure or a pressurized condition, and an air or oxygen atmosphere. The preferable sintering temperature is approximately 800 to 1000°C, and the preferable sintering time is approximately 2 to 64 hours. The calcined product obtained above is pulverized and the resultant powder is molded before sintering. In the molding of the powder, conventional molding methods such as uniaxial pressurizing molding or CIP (i.e., cold isotropic pressing) molding may be used.

In the process of the present invention, since a solution containing ions of rare earth elements, alkaline earth elements, and copper is used for the preparation of the starting material powder, a mixture containing oxalates of the rare earth elements, the alkaline earth elements, and copper uniformly dispersed therein can be obtained only if the mixture is thoroughly stirred.

An alcohol treatment can reduce the surface tension, to prevent the precipitation of oxalates from agglomeration, whereby a powder with a good dispersibility can be synthesized.

Further, by adding ammonia water to the solution in which oxalates are precipitated, ammonium oxalate is formed, and since the ammonium oxalate exists between the particles of oxalates, it controls the agglomerated state, and at the same time, prevents growth of the particle during calcination.

Furthermore, according to the preferred embodiment of the present invention, the mixture of the oxalates of the rare earth elements, alkaline earth elements, and copper is calcined while subjected to an oxygen stream and, therefore, the particle growth of the powder obtained by the calcining can be suppressed. That is, when the oxygen concentration is high, among two types of crystal phases (i.e., ortho-rhombic and tetragonal phases) of the super-conductive oxides such as $YBa_2Cu_3O_{7-x}$, the formation of the tetragonal phase having a small oxygen content (i.e., the value x in the above-mentioned formula is large) becomes difficult. The size of the tetragonal crystal tends to increase, compared with the ortho-rhombic crystal, and therefore, depressing the formation of the tetragonal phase presents the particles from growing. Accordingly, the calcination can be carried out at a higher temperature. For example, when the calcining temperature is increased to 950°C, the particle size obtained is almost the same as that conventionally obtained at a calcining temperature of 900°C. As mentioned above, according to the preferable embodiment of the present invention, a fine and uniform powder composed only of the superconductive phase can be obtained.

According to the present invention, superconductive ceramics having a dense structure can be synthesized. By this process, the critical temperature, the critical current density, and the critical magnetic field become higher, and thus it is possible to improve the performances of electrical instruments and electronic devices.

## Examples

The present invention will now be further illustrated by, but is by no means limited to, the following Examples.

## Example 1

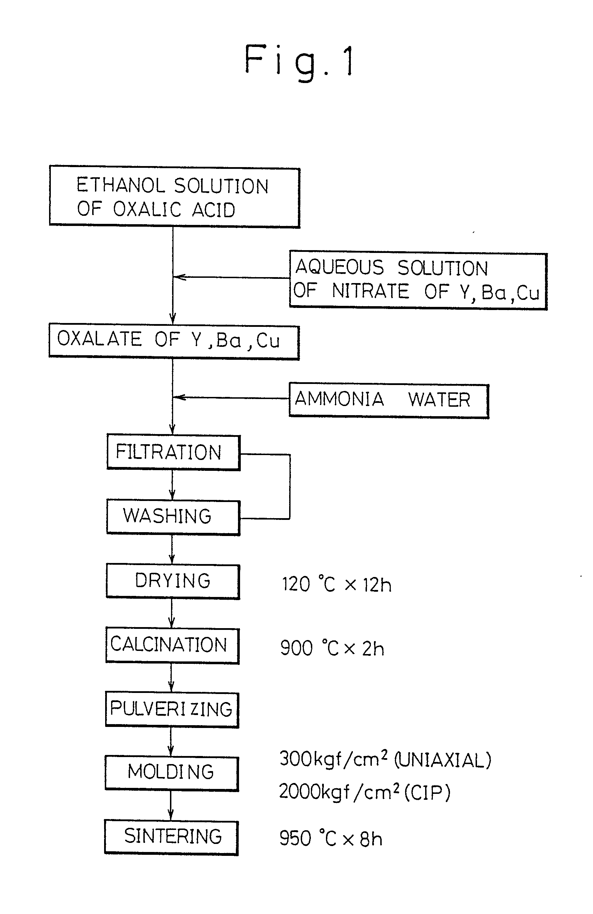

Figure 1 is a flow chart showing an example of the working steps of the process for a synthesis of superconductive ceramics according to the present invention.

As shown in the Figure, first a mixture of aqueous solutions of nitrates of Y, Ba and Cu was added into an ethanolic solution of oxalic acid to precipitate oxalates of Y, Ba and Cu. Subsequently, ammonia water was dropwise added into this solution to adjust the pH to 6.2, and the above solution was then filtered to obtain oxalates of Y, Ba and Cu. The oxalates of Y, Ba and Cu were then repeatedly washed with ethanol and filtrated, followed by a removal of impurities.

The precipitates of oxalates of Y, Ba, and Cu were dried at 120°C for 12 hours and pulverized, and the resultant fine powder of oxalates of Y, Ba, and Cu was calcined by heating at 900°C for 2 hours. The calcined product was then pulverized and primarily pressed into pellets 20 mm in diameter, followed by cold isotropic pressure molding under a molding pressure of 2000 kgf/cm$^2$ and sintering at 950°C for 8 hours, to obtain a superconductive ceramics.

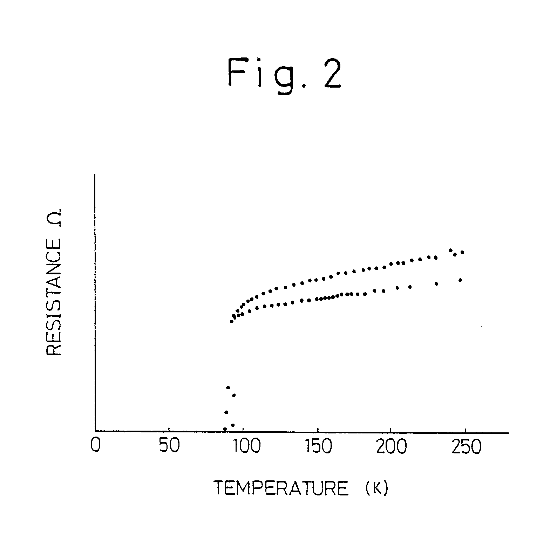

The graph in Fig. 2 shows the results of measurements of the electrical resistance of two samples of different lots prepared by the above working steps. As shown in the graph, a superconductive phenomenon was exhibited at about 90 K with a good reproducibility, and the resistance of the sample with a higher critical temperature Tc became absolutely zero at 92 K.

The critical current density Jc at 77 K of the above sample was 120 A/cm$^2$.

## Example 2

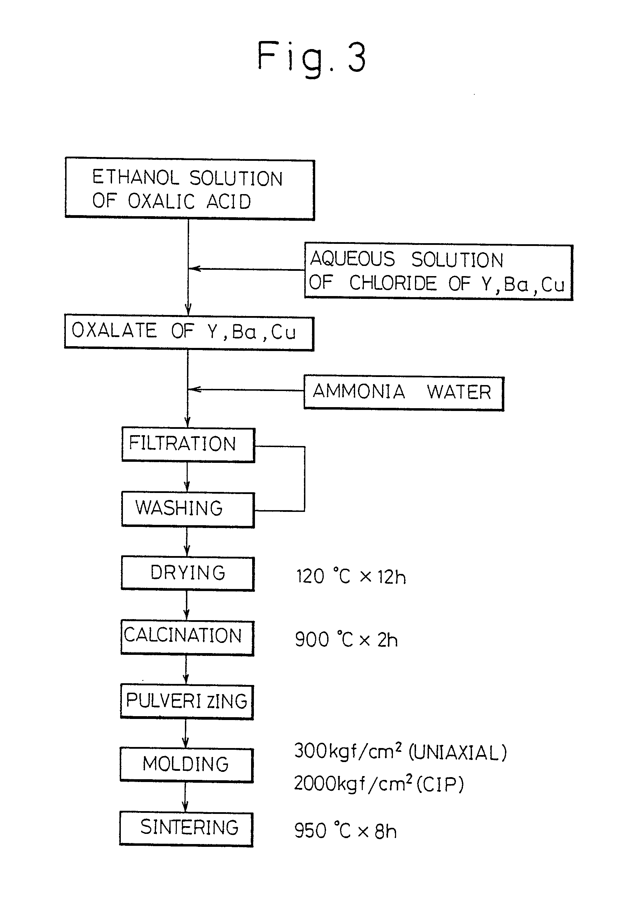

As shown in Fig. 3, by using aqueous solutions of chlorides of Y, Ba, and Cu in an ethanolic solution of oxalic acid, precipitates of Y, Ba, and Cu were obtained.

The precipitates were calcined according to the same method as in Example 1, and the critical temperature Tc was measured. As a result, superconductivity was exhibited at about 90 K, and the resistance became absolutely zero at 92 K, to give substantially the same result as in Example 1.

The same results were also obtained in experiments using other aqueous solutions such as hydroxides of Ba or sulfates of Cu and Y, and homogeneous ceramics were produced from any solution containing ions of a rare earth element, an alkaline earth metal, and Cu.

In accordance with the above described synthesis of $YBa_2Cu_3O_{7-x}$ , other materials, for example, $LaBa_2Cu_3O_{7-x}$ , can be similarly synthesized.

## Example 3

A superconductive oxide of $YBa_2Cu_3O_{7-x}$ was produced.

A mixture of aqueous solutions of chlorides of Y, Ba and Cu was added into an ethanol solution of oxalic acid to precipitate oxalates of Y, Ba and Cu. Subsequently, ammonia water was dropwise added into this solution to adjust the pH to 6.2, and the above solution was then filtered to obtain oxalates of Y, Ba and Cu. The oxalates of Y, Ba and Cu were then repeatedly washed with ethanol and filtered, followed by the removal of impurities.

The precipitates of oxalates of Y, Ba, and Cu obtained above were dried at 120°C for 12 hours and pulverized, and the resultant fine powder of oxalates of Y, Ba, and Cu was calcined by heating at 950°C for 4 hours, while subjected to an oxygen stream under a static pressure of 1 atm and a flow rate of 1 liter/liter min. The calcined product had a composition of $YBa_2Cu_3O_{7-x}$.

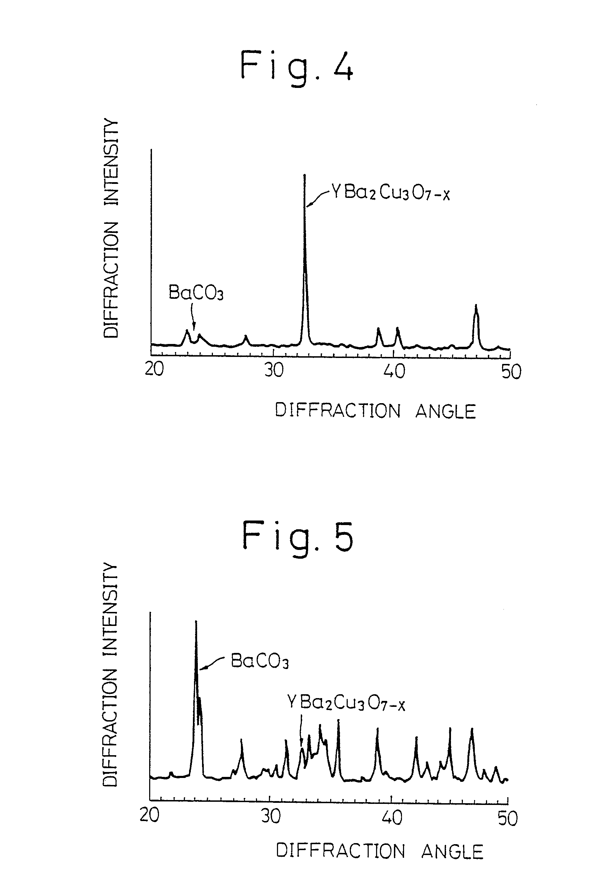

As a reference example, a superconductive oxide powder having a composition of $YBa_2Cu_3O_{7-x}$ was produced by calcining the above-mentioned oxalates upon heating at 900°C for 2 hours under an air atmosphere. The X-ray diffraction intensities of the two samples obtained by calcining in the atmosphere of oxygen and air were measured, and the results are shown in Figs. 4 and 5, respectively.

Figure 4 shows that the superconductive oxide powder according to the present invention is substantially composed of a single phase of $YBa_2Cu_3O_{7-x}$. On the other hand, Fig. 5 shows that the reference superconductive oxide powder $YBa_2Cu_3O_{7-x}$ containing a major amount of $Y_2O_3$, $BaCO_3$, and $CuO$.

In addition, the average diameter of the calcined powder according to the present invention was 1.1 $\mu m$, whereas the average diameter of the reference sample was 1.2 $\mu m$. According to the present invention, even when the calcining is carried out at a high temperature for a long time, the particle growth can be suppressed and the desired fine calcined powder can be obtained.

Furthermore, the critical current density Jc at 77 K of the superconductive ceramics made from powder obtained by the method according to the present invention was 400 $A/cm^2$, whereas the critical current density Jc of the reference sample was 120 $A/cm^2$.

Although the above description was of the synthesis of $YBa_2Cu_3O_{7-x}$, other materials, for example, $LaBa_2Cu_3O_{7-x}$ can be similarly synthesized.

## Claims

1. A process for producing superconductive ceramics comprising the steps of:

(i) adding a solution containing ions of at least one rare earth element, at least one alkaline earth element and copper into an alcoholic solution of oxalic acid to precipitate oxalates of the rare earth elements, the alkaline earth elements, and Cu;

(ii) dropwise adding ammonia water to the solution in which the oxalates are precipitated to adjust a pH thereof to 2 to 7; and

(iii) calcining, molding, and sintering the mixture of oxalates of said rare earth elements, alkaline earth metals, and Cu obtained by filtration of said solution.

2. A process as claimed in claim 1, wherein said rare earth element ions are in the form of a nitrate, chloride, or bromide.

3. A process as claimed in claim 1 or 2, wherein said alkaline earth element ions are in the form of a nitrate, chloride, bromide, hydroxide, oxychloride, thiosulfate, or carboxylate.

4. A process as claimed in claims 1 to 3, wherein said Cu ions are in the form of a nitrate, chloride, or bromide.

5. A process as claimed in claims 1 to 4, wherein said calcining and sintering are carried out under an oxygen stream.

6. A process as claimed in claim 5, wherein the calcination is carried out at a temperature of 800°C to 1200°C for 2 to 48 hours.

7. A process as claimed in claim 5 or 6, wherein the sintering is carried out at a temperature of 800°C to 1000°C for 2 to 64 hours under an air or oxygen atmosphere.

# Fig.1

```
┌─────────────────────┐
│  ETHANOL SOLUTION   │
│  OF OXALIC ACID     │
└─────────────────────┘
          │
          │         ┌──────────────────────────┐
          │◄────────│  AQUEOUS SOLUTION        │
          │         │  OF NITRATE OF Y,Ba,Cu   │
          ▼         └──────────────────────────┘
┌─────────────────────┐
│ OXALATE OF Y,Ba,Cu  │
└─────────────────────┘
          │
          │         ┌──────────────────────────┐
          │◄────────│  AMMONIA   WATER         │
          ▼         └──────────────────────────┘
    ┌──────────────┐
    │  FILTRATION  │───┐
    └──────────────┘   │
          │            │
          ▼            │
    ┌──────────────┐   │
    │   WASHING    │───┘
    └──────────────┘
          │
          ▼
    ┌──────────────┐
    │   DRYING     │      120 ℃ × 12h
    └──────────────┘
          │
          ▼
    ┌──────────────┐
    │ CALCINATION  │      900 ℃ × 2h
    └──────────────┘
          │
          ▼
    ┌──────────────┐
    │ PULVERIZING  │
    └──────────────┘
          │
          ▼
    ┌──────────────┐      300kgf/cm² (UNIAXIAL)
    │   MOLDING    │
    └──────────────┘      2000kgf/cm² (CIP)
          │
          ▼
    ┌──────────────┐
    │  SINTERING   │      950 ℃ × 8h
    └──────────────┘
```

# Fig. 2

0 287 064

# Fig. 3

```
┌─────────────────────────┐
│  ETHANOL SOLUTION       │
│  OF OXALIC ACID         │
└─────────────────────────┘
            │                    ┌──────────────────────────────┐
            │←───────────────────│  AQUEOUS  SOLUTION           │
            │                    │  OF  CHLORIDE OF Y,Ba,Cu     │
            ↓                    └──────────────────────────────┘
┌─────────────────────────┐
│  OXALATE  OF  Y,Ba,Cu   │
└─────────────────────────┘
            │                    ┌──────────────────────────────┐
            │←───────────────────│  AMMONIA  WATER              │
            ↓                    └──────────────────────────────┘
     ┌──────────────┐
     │  FILTRATION  │────┐
     └──────────────┘    │
            │            │
     ┌──────────────┐    │
     │  WASHING     │────┘
     └──────────────┘
            │
     ┌──────────────┐
     │   DRYING     │        120 °C × 12h
     └──────────────┘
            │
     ┌──────────────┐
     │  CALCINATION │        900 °C × 2h
     └──────────────┘
            │
     ┌──────────────┐
     │ PULVERIZING  │
     └──────────────┘
            │
     ┌──────────────┐        300kgf/cm² (UNIAXIAL)
     │   MOLDING    │
     └──────────────┘        2000kgf/cm² (CIP)
            │
     ┌──────────────┐
     │  SINTERING   │        950 °C × 8h
     └──────────────┘
```

# Fig. 4

X-axis: DIFFRACTION ANGLE (20 to 50)
Y-axis: DIFFRACTION INTENSITY

$YBa_2Cu_3O_{7-x}$

$BaCO_3$

# Fig. 5

X-axis: DIFFRACTION ANGLE (20 to 50)
Y-axis: DIFFRACTION INTENSITY

$BaCO_3$

$YBa_2Cu_3O_{7-x}$